# EUROPEAN PATENT APPLICATION

(11) **EP 4 794 514 A1**
(43) Date of publication of application: **19.08.2026**
(21) Application number: 26158424.7
(22) Date of filing: 13.02.2026
(51) Int. Cl.: H10W 72/20, H10W 40/20, H10W 40/25, H10W 72/30

(54) **A STRAIN CONTROL DEVICE OF A SEMICONDUCTOR PACKAGE, A SEMICONDUCTOR PACKAGE INCLUDING THE STRAIN CONTROL DEVICE, AND A SEMICONDUCTOR MODULE INCLUDING THE SEMICONDUCTOR PACKAGE**

(30) Priority: 13.02.2025 KR 20250019015; 18.02.2025 KR 20250020987; 11.03.2025 KR 20250031465; 08.01.2026 KR 20260003262
(71) Applicant: LX Semicon Co., Ltd., Daejeon 34027 (KR)
(72) Inventor: LEE, Sang Rae, 34027 Daejeon (KR); RA, Se Woong, 34027 Daejeon (KR); KIM, Jin Gyu, 34027 Daejeon (KR); OH, Hee Bong, 34027 Daejeon (KR)
(74) Representative: Goddar, Heinz J.

(57) **Abstract**

An embodiment relates to a strain control device of a semiconductor package, a semiconductor package including the strain control device, and a semiconductor module including the semiconductor package. A strain control device of a semiconductor package according to an embodiment may include a body, a plurality of spaced apart first connection members disposed in a first region under the body, and a conductive paste layer disposed in a second region under the body.

## Description

### TECHNICAL FIELD

The present invention relates to a semiconductor package, and more specifically, to a device for controlling strain and heat flow of a semiconductor package, a semiconductor package including the same, and a semiconductor module including the semiconductor package.

### BACKGROUND

As high performance and miniaturization of electric and electronic products rapidly progress, a plurality of semiconductor devices are highly integrated and disposed in a semiconductor package. Such a package structure has advantages in that a mounting area can be efficiently utilized and high-speed signal transmission is possible, but heat generated from the semiconductor devices and a resulting increase in strain are becoming a cause of reliability degradation, so heat and strain management technology at a package level is being recognized as an important task.

Semiconductor packages are being applied to various electronic devices such as smartphones, servers, network systems, computers, tablets, and automotive electronic devices, and particularly in a high-performance computing environment such as a data center, heat generation occurring in a semiconductor package and a resulting reliability problem are being recognized as important technical tasks according to expansion of AI semiconductor introduction. Accordingly, a technology for properly controlling heat management and accompanying strain in a semiconductor package is required.

Particularly, since HBM (High Bandwidth Memory) has a multi-stacked structure using a TSV (Through-Silicon Via), power density and heat generation density are high, and heat dissipation paths are limited, so heat management is essential. When HBM is applied to a personal electronic device having a small form factor, it may be disposed in a form of a SIP (System In Package) combined with an application processor (AP) as one package. In this case, since a memory device relatively vulnerable to heat is disposed adjacent to a logic chip or the like within a narrow space, if the flow of heat is not properly controlled, heat generated from the logic chip is transferred to the HBM, which may degrade the reliability of the memory device. Therefore, in order to stably operate HBM in such an environment, a technology for effectively distributing and controlling heat generation through a package structure is required.

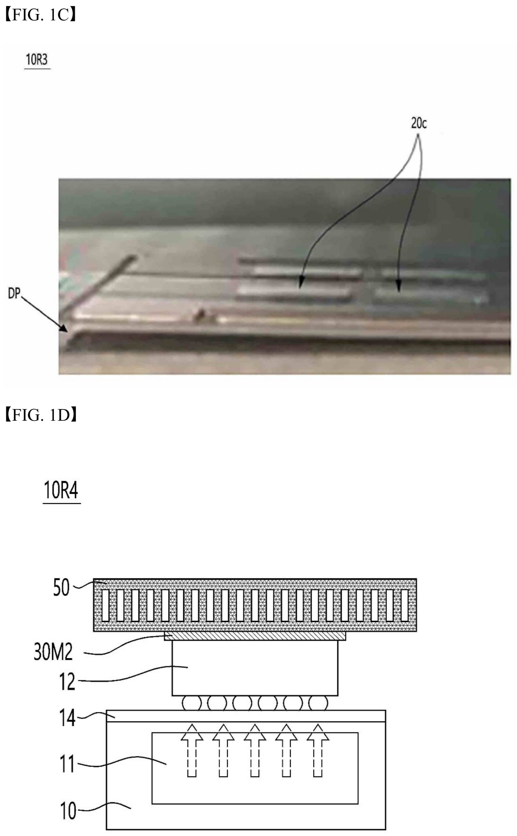

For example, FIG. 1D is a cross-sectional view of a semiconductor package 10R4 according to a third comparative example.

A semiconductor package 10R4 according to a fourth comparative example may include a first semiconductor device 11 disposed on a first substrate 10, and a second semiconductor device 12 disposed on a conductive layer 14 on the first substrate 10.

The first substrate 10 may include at least any one of a plurality of insulating layers, wiring layers, and via electrodes. The first semiconductor device 11 may be a semiconductor chip including an active device and/or a passive device, and for example, an integrated circuit (IC), an application processor (AP), a CPU, a GPU, a digital signal processor, a cryptographic processor, a microprocessor, a microcontroller, an ASIC, or a SoC (System on Chip) including a combination thereof may be applied as the first semiconductor device 11.

Meanwhile, the second semiconductor device 12 may be a memory chip, and for example, may include various types of memory such as a stack memory like HBM, a DRAM, a ROM, and a flash memory.

According to the semiconductor package 10R4 of the fourth comparative example, in a process in which heat generated from the first semiconductor device 11 is moved to a heat sink or a vapor chamber, etc., thermal stress can be generated in the adjacent second semiconductor device 12 to degrade reliability. This was not a big problem in the past, but as the amount of heat generated from high-performance logic devices such as an AP, an ASIC, or a SoC increases recently, a thermal interference problem in which heat generated from a logic device affects an adjacent memory device is emerging, so the necessity of a technology for properly controlling heat flow within a package is increasing.

Also, meanwhile, in a high-power environment such as a hybrid and an electric vehicle, a SiC-based power semiconductor module is used, and in such a module, junction degradation, thermal concentration, thermal runaway, etc. can occur due to a high temperature and repeated thermal cycles. Accordingly, a heat and strain control technology for securing a stable operation even under a high-power driving condition is also importantly required.

To improve heat dissipation performance of a semiconductor package, various heat dissipation structures such as a heat sink, a heat dissipation plate, a heat pipe, and a vapor chamber are being utilized. However, even in such structures, reliability problems such as thermal concentration, warpage, cracks, voids, and delamination can occur due to a difference in material properties of a bonding layer disposed in a heat transfer path, particularly, a difference in thermal conductivity and coefficient of thermal expansion (CTE).

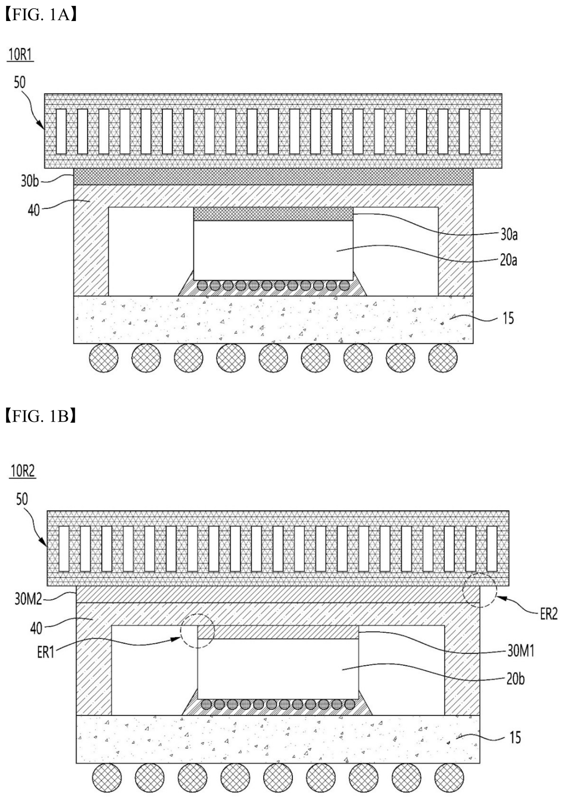

FIG. 1A is a cross-sectional view of a semiconductor package 10R1 according to a first comparative example.

In the semiconductor package 10R1 of the first comparative example, a heat dissipation plate 40 in a form of a metal lid is disposed on a first electronic device 20a to discharge heat occurring in the first electronic device 20a in an upward direction, and the first electronic device 20a and the heat dissipation plate 40 may be bonded by a first adhesive layer 30a of a polymer-based material. Also, a heat sink 50 is disposed on the heat dissipation plate 40, and the heat dissipation plate 40 and the heat sink 50 may be bonded by a second adhesive layer 30b of a polymer-based material.

However, since the first adhesive layer 30a and the second adhesive layer 30b of the polymer-based material have relatively low thermal conductivity, heat generated from the first electronic device 20a cannot be efficiently diffused and can be concentrated in a specific area, so there is a problem that heat dissipation efficiency is lowered. Accordingly, the semiconductor package 10R1 of the first comparative example had a problem that as a temperature of the first electronic device 20a increases, driving power is lowered to lower the temperature by itself, and performance is lowered to 30% or less.

FIG. 1B is a cross-sectional view of a semiconductor package 10R2 according to a second comparative example.

In the second comparative example, a metal TIM (Thermal Interface Material) or the like may be applied to a first metal adhesive layer 30M1 and a second metal adhesive layer 30M2 to improve heat transfer.

However, since a difference in coefficient of thermal expansion exists between the heat dissipation plate 40 and the second electronic device 20b, or between the heat dissipation plate 40 and the heat sink 50, when a temperature of the second electronic device 20b rapidly increases, warpage occurs and stress can be concentrated at an interface, and accordingly, cracks or voids occur in the metal adhesive layer, which can lead to delamination. For example, FIG. 1C is a photograph in which delamination DP occurred in the semiconductor package 10R2 according to the second comparative example.

Referring back to FIG. 1B, in the second comparative technique using a metal TIM (Thermal Interface material), when the temperature of the second electronic device 20b rapidly increases, a relatively large strain can occur at an interface having a large difference in coefficient of thermal expansion, such as a first edge region ER1 of the first metal adhesive layer 30M1 or a second edge region ER2 of the second metal adhesive layer 30M2, and if such stress concentration is repeated, there is a possibility that a reliability problem such as delamination occurs.

As such, in a high-performance semiconductor package, a structural technology is required, which can simultaneously solve strain and delamination problems occurring due to CTE mismatch between materials while efficiently discharging heat generated from electronic devices.

### SUMMARY

One of technical problems of the embodiment is to solve a problem that when a temperature of an electronic device rapidly increases in a conventional technology using a TIM, cracks or voids occur in an edge region of an adhesive layer due to a difference in coefficient of thermal expansion, which leads to delamination.

Also, one of technical problems of the embodiment is to provide a structure for alleviating a technical contradiction in which delamination occurs at a bonding interface due to a difference in coefficient of thermal expansion between adjacent materials while efficiently transferring heat occurring in an electronic device upward.

Also, one of technical problems of the embodiment is to solve a problem that in a process in which heat generated from a logic chip or the like is moved to a heat sink or a vapor chamber, etc., excessive thermal stress is given to a memory device such as HBM to degrade reliability, by controlling the flow of heat within a package.

Also, it is one of technical problems of the embodiment to improve reliability of a power semiconductor module by alleviating problems of strain concentration inside a package and junction degradation occurring due to repeated thermal cycles under high-temperature and high-power conditions.

Technical problems of the present invention are not limited to the contents described above, and include various technical problems that can be understood by those skilled in the art through the following description of the invention and embodiments.

A strain control device of a semiconductor package according to an embodiment may include a body 110, a plurality of spaced apart first connection members 112 disposed in a first region under the body 110; and a conductive paste layer 114 disposed in a second region under the body 110.

The conductive paste layer 114 may include any one or more of a solder paste layer, a metal paste, or a metal TIM.

The first connection member 112 may be disposed in an outer area or a corner area of the first region of the body 110, and the conductive paste layer 114 may be disposed in a central area of the body 110.

The conductive paste layer 114 may include a plurality of spaced apart conductive paste layers, and may include a first conductive paste layer 114a in a central area and a second conductive paste layer 114b, a third conductive paste layer 114c, or a fourth conductive paste layer 114d, a fifth conductive paste layer 114e disposed in an outer area spaced apart therefrom in a horizontal or vertical direction.

The first connection member 112 may include a plurality of first connection members 112 disposed in a corner area of the body 110, and some may be disposed to overlap a conductive paste layer disposed in an outer area in a vertical direction.

A first roughness 110R1 of the first region where the conductive paste layer 114 is formed may be greater than a second roughness 110R2 in the second region.

The body 110 may include a body protrusion 110P and an exposed portion 110B.

The first connection member may include a metal ball 112B1 and a solder cover layer 112B2 surrounding the metal ball 112B1.

The first connection member may include a metal pillar 112C1 and a second solder cover layer 112C2 surrounding the metal pillar 112C1.

Also, the embodiment further includes a heat flow control layer 150 disposed on a side surface of the body 110,

The heat flow control layer 150 may include a plating layer.

Also, a semiconductor package of the embodiment may include a first semiconductor device 211 disposed on a first package substrate 210a, a strain control device 101 disposed on the first semiconductor device 211, and a second semiconductor device 212 disposed to be spaced apart on a side surface of the first strain control device 101.

The strain control device 101 may include the strain control device of any one of the semiconductor packages.

Also, a semiconductor module of the embodiment may include any one of the semiconductor packages.

A strain control device, a semiconductor package, and a semiconductor module according to the present embodiment can provide the following effects.

Even if a temperature of an electronic device increases rapidly, since the first connection members 112 are spaced apart to distribute thermal expansion stress, problems of cracks, voids, and delamination occurring in an edge region of an adhesive layer can be suppressed. Particularly, when the first connection member is a solder ball, a stress distribution effect can be increased by a structure spaced apart between solder balls, so heat dissipation efficiency and reliability of a junction can be improved.

Also, according to the strain control device 101 of the embodiment, by disposing the conductive paste layer 114 having a high thermal conductivity characteristic in a central area and disposing the connection members 112 in an outer/corner area where thermal stress is large in consideration of a maximum strain occurrence region, heat transfer performance improved by about 400 to 500% compared to a full-surface TIM structure of a comparative technique can be ensured.

The strain control device 101 disposed to overlap the first semiconductor device 211 can intensively form a heat flow F1 in an upward direction, and the heat flow control layer 150 on a side surface can minimize thermal damage to a memory device and can improve reliability by suppressing a heat flow F2 toward the second semiconductor device 212 such as HBM.

A concavo-convex portion 110R formed on a body of a second strain control device 102 can decrease a possibility of delamination by increasing a contact area and adhesive force with an upper heat dissipation device and can maximize performance of an upper heat dissipation path.

Technical effects of the embodiment are not limited to those described in this section and include those that can be identified through the description of the invention.

### BRIEF DESCRIPTION OF THE DRAWINGS

The accompanying drawings, which are incorporated herein and form part of the specification, illustrate various, non-limiting embodiments of the present invention. In the drawings, like reference numbers indicate identical or functionally similar elements.
FIG. 1A is a cross-sectional view of a semiconductor package 10R1 according to a first comparative example.
FIG. 1B is a cross-sectional view of a semiconductor package 10R2 according to a second comparative example.
FIG. 1C is a photograph of a delamination problem DP in a semiconductor package 10R3 according to a third comparative example.
FIG. 1D is a cross-sectional view of a semiconductor package 10R4 according to a fourth comparative example.
FIG. 2A is a cross-sectional view of a semiconductor package module 1000 according to an embodiment.
FIG. 2B is a specific drawing of the semiconductor package module 1000 according to the embodiment shown in FIG. 2A.
FIG. 3A is a cross-sectional view of a first semiconductor package 210A according to a first embodiment.
FIG. 3B is a detailed drawing of the first semiconductor package 210A according to the first embodiment shown in FIG. 3A.
FIG. 4 is a detailed drawing of a first strain control device 101 according to an embodiment.
FIG. 5 is a first bottom view example of the first strain control device 101 of FIG. 4.
FIG. 6 is a second bottom view example of the first strain control device 101 of FIG. 4.
FIG. 7A is stress distribution data in a heat dissipation block of a comparative technique.
FIG. 7B is stress distribution data in the strain control device 101 according to the embodiment.
FIG. 8 is a cross-sectional view of a second strain control device 102 according to an embodiment.
FIG. 9 is a cross-sectional view of a third strain control device 103 according to an embodiment.
FIG. 10A is a bottom view example of a fourth strain control device 104.
FIG. 10B is a cross-sectional view of the fourth strain control device 104 shown in FIG. 10A.
FIG. 11A is a bottom view example of a fifth strain control device 105.
FIG. 11B is a cross-sectional view of the fifth strain control device 105 shown in FIG. 11A.
FIG. 12A is a cross-sectional view of a sixth strain control device 106 according to an embodiment.
FIG. 12B is a cross-sectional view of a first-second connection member 112B in the sixth strain control device 106.
FIG. 12C is a cross-sectional view of a first-third connection member 112C in the sixth strain control device 106.
FIG. 13A to FIG. 13C are exemplary views of semiconductor packages according to third to fifth embodiments.

### DETAILED DESCRIPTION

Hereinafter, embodiments disclosed in the present specification will be described in detail with reference to the accompanying drawings. A suffix 'module' and 'part' for components used in the following description are given or used interchangeably in consideration of ease of preparation of the specification, and do not have meanings or roles distinguished from each other by themselves. Also, the accompanying drawings are for easily understanding the embodiments disclosed in the present specification, and the technical idea disclosed in the present specification is not limited by the accompanying drawings. Also, when an element such as a layer, a region, or a substrate is referred to as being 'on' another component, this includes that it exists directly on the other element or another intermediate element may exist therebetween.

### (Embodiment)

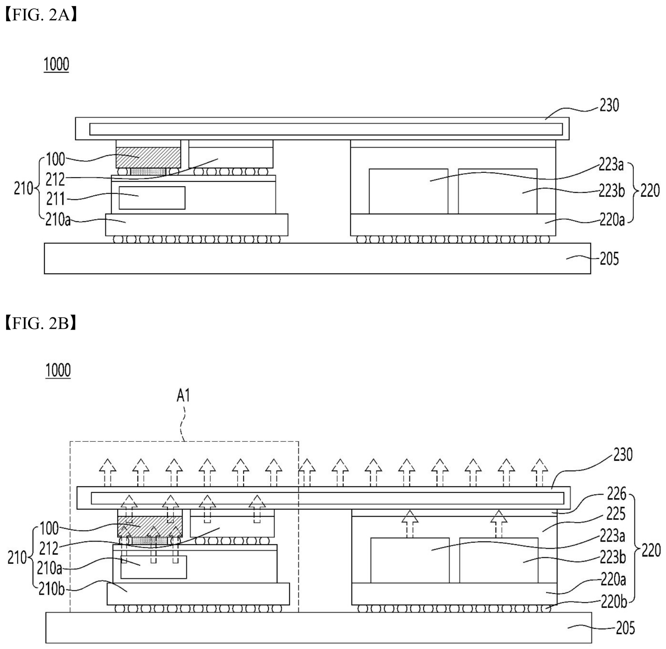

FIG. 2A is a cross-sectional view of a semiconductor package module 1000 according to an embodiment, and FIG. 2B is a specific drawing of the semiconductor package module 1000 according to the embodiment shown in FIG. 2A.

Referring to FIG. 2A, a semiconductor package module 1000 according to an embodiment may include one or more semiconductor packages 210 and 220 and a heat dissipation device 230 disposed on a main board 205.

A product family to which the semiconductor package of the embodiment is applied may be any one of CSP (Chip Scale Package), FC-CSP (Flip Chip-Chip Scale Package), FC-BGA (Flip Chip Ball Grid Array), POP (Package On Package), and SIP (System In Package), but is not limited thereto.

The main board 205 may be physically and/or electrically connected to other circuit components, and a semiconductor package mounted thereon may have various configurations.

A first semiconductor package 210 may include a single or a plurality of semiconductor devices 211 and 212 disposed on a first package substrate 210a and a strain control device 100 disposed to overlap at least one of these semiconductor devices.

In the embodiment, the strain control device 100 may simultaneously perform a heat flow control function.

For example, a first semiconductor device 211 is disposed on a first package substrate 210a, and a second semiconductor device 212 may be disposed to be spaced apart on an upper side of the first semiconductor device 211. The strain control device 100 may be disposed to overlap the first semiconductor device 211 in a vertical direction.

The first package substrate 210a may include at least any one of a plurality of insulating layers, wiring layers, and via electrodes, and may further include an interposer substrate (not shown) to mount the first semiconductor device 211 and the second semiconductor device 212 on the interposer substrate, but is not limited thereto.

The first semiconductor device 211 and the second semiconductor device 212 may include an active device and/or a passive device. For example, the active device may be an integrated circuit (IC) in which a plurality of devices are integrated, an application processor (AP), a CPU, a GPU, a digital signal processor, a processor for encryption, a microprocessor, a microcontroller, an ASIC, or a SoC (System on Chip).

Also, a memory chip may be a stack memory such as HBM, and may be implemented as various types of memory such as a DRAM and a flash memory.

Hereinafter, the first semiconductor device 211 is a logic chip and the second semiconductor device 212 is described as being a memory chip, but the embodiment is not limited thereto.

Also, the second semiconductor package 220 may include a single or a plurality of semiconductor devices 223a and 223b disposed on a second package substrate 220a.

For example, the second semiconductor package 220 may include a third-first semiconductor device 223a and a third-second semiconductor device 223b disposed to be spaced apart on the second package substrate 220a.

These semiconductor devices also may include an active device or a passive device, and may be implemented in various forms such as a logic chip or a memory chip.

Next, a semiconductor package module 1000 according to an embodiment may include a heat dissipation device 230 disposed on a first semiconductor package 210 and a second semiconductor package 220. The heat dissipation device 230 may be a vapor chamber, but is not limited thereto.

According to an embodiment, when heat generated from the first semiconductor package 210 and the second semiconductor package 220 is transferred to a lower metal plate of the heat dissipation device 230, a working fluid is vaporized to absorb latent heat of evaporation, and can be condensed into a liquid while moving toward an upper metal plate and releasing the latent heat of evaporation. The condensed working fluid can be absorbed into a trench structure of a hollow structure and moved toward the lower metal plate.

Next, referring to FIG. 2B, in the first semiconductor package 210, a first package substrate 210a may be mounted by the main board 205 and a first adhesive member 210b. The first adhesive member 210b may be a solder ball, but is not limited thereto.

Also, in the second semiconductor package 220, a second package substrate 220a may be mounted by a third adhesive member 220b. The third adhesive member 220b may be a solder ball, but is not limited thereto.

The third-first semiconductor device 223a and the third-second semiconductor device 223b may be disposed in a second package body 225, and the second package body 225 may be bonded to the heat dissipation device 230 by a fourth adhesive layer 226. The second package body 225 may include at least any one of a plurality of insulating layers, wiring layers, and via electrodes, but is not limited thereto.

The fourth adhesive layer 226 may be a metal adhesive layer including a metal material, but is not limited thereto. For example, the fourth adhesive layer 226 may include a Sn alloy adhesive layer, an In alloy adhesive layer, an Al alloy adhesive layer, and the like, but is not limited thereto.

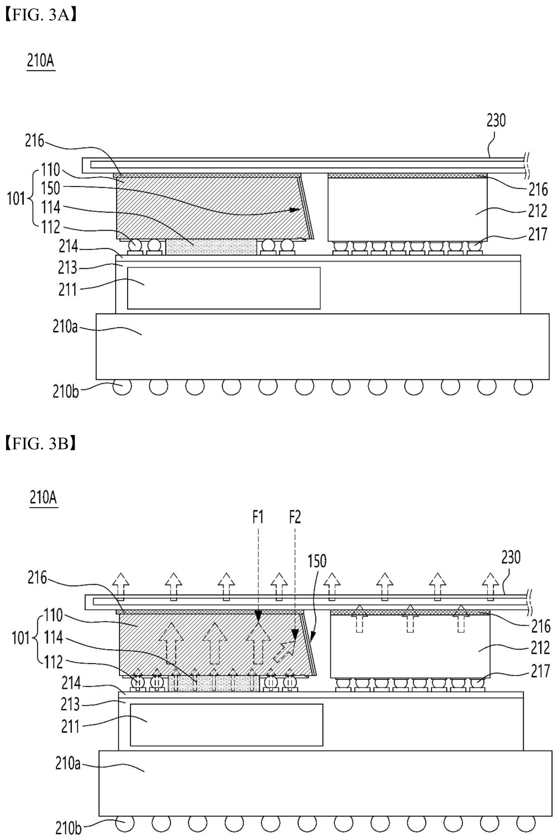

Characteristics of the first semiconductor package 210 will be described in detail later based on FIG. 3A to FIG. 3B.

According to a semiconductor package according to an embodiment, it is possible to solve a problem of a technical contradiction in which delamination of a junction occurs due to a difference in coefficient of thermal expansion between adjacent materials while efficiently transferring heat generated from a semiconductor device or the like upward.

Also, according to an embodiment, a problem in which reliability is degraded due to concentration of thermal stress on a memory device such as HBM in a process where heat generated from a logic chip or the like is moved to a heat sink or a vapor chamber, etc., can be solved through a heat flow control structure.

Hereinafter, technical characteristics of an embodiment will be described in detail with reference to FIG. 3A and FIG. 3B.

FIG. 3A is an enlarged view of a first region A1 of the semiconductor package module 1000 according to the embodiment shown in FIG. 2B and is a cross-sectional view of a first semiconductor package 210A according to a first embodiment, and FIG. 3B is a detailed drawing of the first semiconductor package 210A according to the first embodiment shown in FIG. 3A. In the following description, 'first embodiment' may be abbreviated as 'embodiment'.

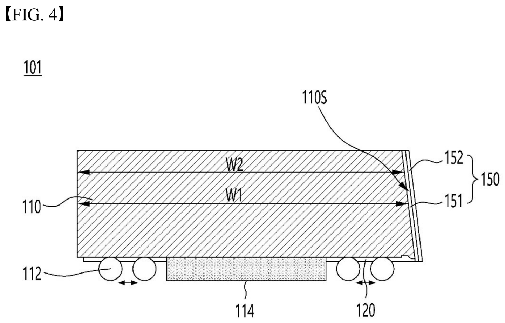

FIG. 4 is a detailed drawing of a first strain control device 101 according to an embodiment.

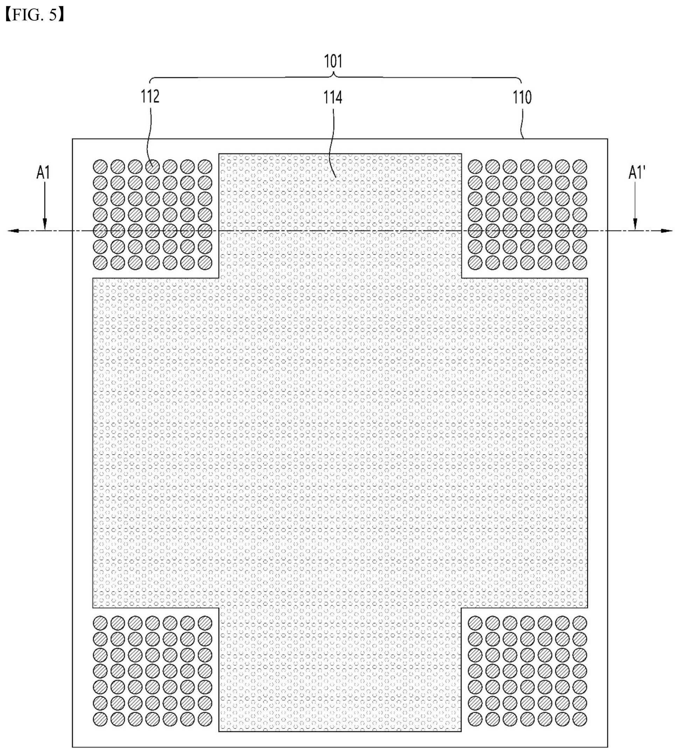

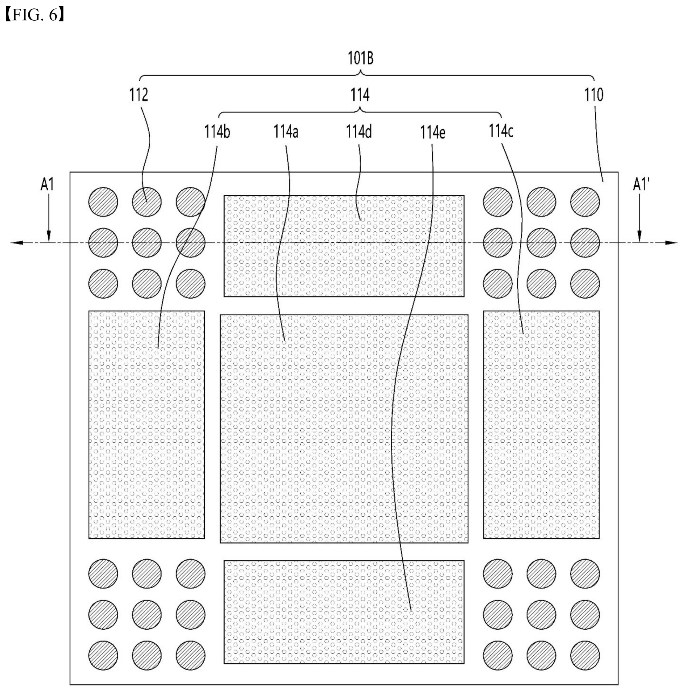

FIG. 5 is an exemplary bottom view of the first strain control device 101 of FIG. 4, and FIG. 4 may be a cross-sectional view taken along line A1-A1' of FIG. 5. Also, FIG. 6 is a second bottom view example of the first strain control device 101 of FIG. 4.

Referring to FIG. 3A, a first semiconductor package 210A according to a first embodiment may include a single or a plurality of semiconductor devices 211 and 212 and a first strain control device 101 disposed on a first package substrate 210a.

For example, the first semiconductor package 210A of the first embodiment may include a first semiconductor device 211 disposed on a first package substrate 210a, a second semiconductor device 212 disposed to be spaced apart on the first semiconductor device 211, and a first strain control device 101.

The first semiconductor device 211 may be disposed in a first package body 213. The first package body 213 may include at least any one of a plurality of insulating layers, wiring layers, and via electrodes, but is not limited thereto.

The first strain control device 101 may include a body 110, a plurality of spaced apart first connection members 112 disposed in a first region under the body 110, and a conductive paste layer 114 disposed in a second region under the body 110. The body 110 may be referred to as a 'strain control body' or a 'heat flow control body'.

The conductive paste layer 114 may be a solder paste layer, a metal TIM, an Ag paste, or the like, but is not limited thereto.

The first connection member 112 may include a conductive ball, for example, a solder ball, but is not limited thereto.

The first strain control device 101 may be disposed to overlap the first semiconductor device 211 in a vertical direction, but is not limited thereto.

Also, in an embodiment, a position of the first strain control device 101 is shown as being disposed on a left side of the second semiconductor device 212, but is not limited thereto, and the position of the first strain control device 101 may be changed according to a position of the first semiconductor device 211 and a position of a heat source in the first semiconductor device 211.

Also, in an embodiment, a size of the first semiconductor device 211 is not limited to the size shown in FIG. 2A and FIG. 2B, and may be disposed large enough to occupy the entire first package body 213.

The second semiconductor device 212 may be disposed on a wiring layer 214 of a metal material with a second connection member 217 interposed therebetween, but is not limited thereto. The wiring layer 214 may be an RDL layer, but is not limited thereto.

The second connection member 217 may include a conductive ball, for example, a solder ball, but is not limited thereto.

Next, FIG. 5 is a first bottom view example of the first strain control device 101 of FIG. 4, and FIG. 6 is a second bottom view example of the first strain control device 101 of FIG. 4.

First, referring to FIG. 5, a strain control device 101 of an embodiment may include a conductive paste layer 114 disposed in a first region of a body 110 and a first connection member 112 disposed in a second region. For example, the conductive paste layer 114 may be a solder paste layer, a metal TIM, an Ag paste, or the like, but is not limited thereto. Also, the first connection member 112 may include a conductive ball, for example, a solder ball, but is not limited thereto.

For example, the strain control device 101 of the embodiment may include a conductive paste layer 114 disposed in a first region of the body 110 and a first connection member 112 disposed in a second region which is outside the first region.

Referring to FIG. 3B and FIG. 4 together, the conductive paste layer 114 may be disposed in a central area of the body 110, and the first connection member 112 may be disposed in both corner areas of the body 110.

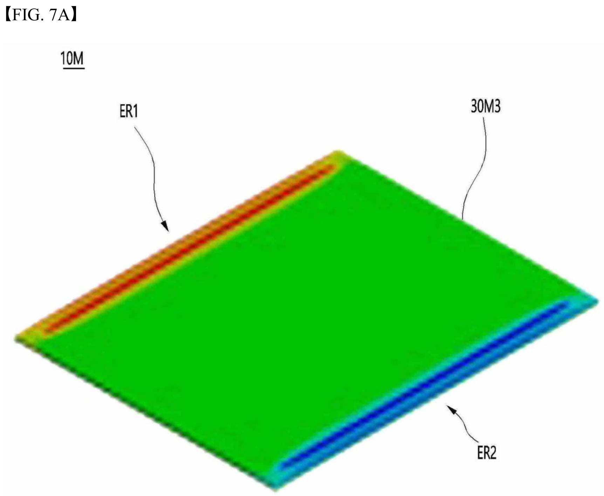

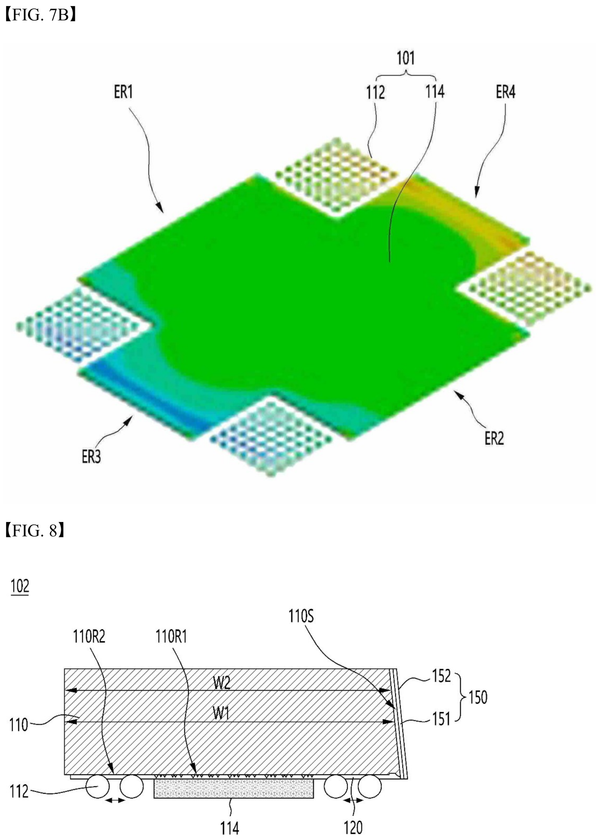

FIG. 7A is stress distribution data in a heat dissipation block 10M of a comparative technique, and FIG. 7B is stress distribution data in a strain control device 101 according to an embodiment.

Referring to FIG. 7A, in a heat dissipation block 10M of a comparative technique using a metal TIM (Thermal Interface material), when a temperature of an electronic device adjacent to the heat dissipation block rapidly increases, maximum stress (Max strain) occurred in a first edge region ER1 of a TIM 30M3 or a second edge region ER2 of a second metal adhesive layer 30M2 due to a difference in coefficient of thermal expansion (CTE) between the TIM 30M3 and a Cu heat dissipation body (not shown). Due to this, there was a problem that cracks or voids occurred in the first edge region ER1 or the second edge region ER2 of the TIM 30M3, leading to delamination.

On the other hand, referring to FIG. 7B, by including a conductive paste layer 114 disposed in a first region of a body 110 and a first connection member 112 disposed in a second region outside the first region, it was confirmed that the maximum strain in first to fourth edge regions ER1, ER2, ER3, and ER4 of the strain control device 101 of the embodiment is reduced by about 50% to 60% compared to the comparative technique under operating conditions equivalent to the comparative technique. As a result, a problem of delamination due to the occurrence of cracks or voids in the edge region is prevented, so that an effect of significantly improving junction reliability can be achieved.

For example, in the strain control device 101 of the embodiment, a first connection member 112 including a conductive ball may be disposed in an outer area or a corner area where maximum strain is concentrated, and a conductive paste layer 114 may be disposed in a central area.

Accordingly, an arrangement of the spaced apart connection members can distribute thermal expansion stress generated according to a CTE difference at a bonding interface, and can provide an effect of preventing voids or cracks by improving compliance due to local expansion and contraction compared to full-surface TIM bonding.

For example, when the first connection member 112 of the strain control device 101 is a solder ball, stress distribution can be possible by the spacing between the balls, and by inducing the thermal expansion stress due to heat generated from the first semiconductor device 211 into a multi-point distribution path, delamination prevention, heat dissipation efficiency, and junction reliability can be improved.

Also, according to an embodiment, the conductive paste layer 114 disposed in the second area can enhance the upward heat flow and can suppress the lateral heat flow, so there is a technical effect that heat conduction increases by about 400 to 500% compared to a comparative technique.

Next, FIG. 6 is a second bottom view example of the first strain control device 101 shown in FIG. 4.

Referring to FIG. 6, in the strain control device 101 of the embodiment, the conductive paste layer 114 can include a plurality of spaced apart conductive paste layers to alleviate strain according to thermal expansion.

For example, the conductive paste layer 114 may include a first conductive paste layer 114a disposed in a central area of the body 110, and a second conductive paste layer 114b or a third conductive paste layer 114c spaced apart from the first conductive paste layer 114a in a horizontal direction and disposed in an outer area.

The strain control device 101 of the embodiment may include a plurality of first connection members 112 disposed in a corner area of the body 110.

In an embodiment, the first connection member 112 disposed in the corner area may be disposed to overlap in a vertical direction with the second conductive paste layer 114b or the third conductive paste layer 114c spaced apart in a horizontal direction and disposed in the outer area.

Also, the conductive paste layer 114 may include a third conductive paste layer 114c or a fifth conductive paste layer 114e spaced apart from the first conductive paste layer 114a in a vertical direction and disposed in the outer area.

In an embodiment, the first connection member 112 disposed in the corner area may be disposed to overlap in a vertical direction with the third conductive paste layer 114c or the fifth conductive paste layer 114e spaced apart in a vertical direction and disposed in the outer area.

Accordingly, a technical effect of distributing and alleviating interface strain according to thermal expansion can be obtained through a combination of the conductive paste layer 114 and the connection member 112.

Referring back to FIG. 3A, the second semiconductor device 212 and an upper portion of the strain control device 101 may be bonded to the heat dissipation device 230 with a second adhesive layer 216 interposed therebetween. The second adhesive layer 216 may be a metal adhesive layer including a metal material, but is not limited thereto. For example, the second adhesive layer 216 may include a Sn alloy adhesive layer, an In alloy adhesive layer, an Al alloy adhesive layer, and the like, but is not limited thereto.

Referring to FIG. 3A and FIG. 4, the first strain control device 101 may include a heat flow control layer 150 disposed on a side surface of the body 110.

Specifically, referring to FIG. 4, the heat flow control layer 150 may include a single or a plurality of heat flow control layers on one side surface of the body 110 in a direction adjacent to the second semiconductor device 212.

For example, the heat flow control layer 150 may include a first heat flow control layer 151 on one side surface of the body 110 in a direction adjacent to the second semiconductor device 212.

Also, the heat flow control layer 150 may further include a second heat flow control layer 152 disposed on the first heat flow control layer 151.

Thermal conductivity of the heat flow control layer 150 may be lower than thermal conductivity of the body 110.

An embodiment may include a first heat flow control layer 151 and a second heat flow control layer 152 sequentially disposed on one side surface of the body 110, and thermal conductivity of the second heat flow control layer 152 may be lower than thermal conductivity of the first heat flow control layer 151, but is not limited thereto.

For example, the body 110 may include a Cu material, and the heat flow control layer 150 may include a Ni material.

Thermal conductivity of the body 110 of the Cu material may be about 401 W/(m·K), and thermal conductivity of the heat flow control layer of the Ni material may be about 90.9 W/(m·K).

For example, the first heat flow control layer 151 may include a Ni plating layer, and the second heat flow control layer 152 may include a gold (Au) plating layer or a palladium (Pd) plating layer, but is not limited thereto. For example, the second heat flow control layer 152 may include an ENIG (Electroless Nickel Immersion Gold) layer or an ENEPIG (Electroless Nickel Electroless Palladium Immersion Gold) layer or an insulating coating material, but is not limited thereto. In an embodiment, thermal conductivity of the heat flow control layer of the Au material may be about 318 W/(m·K), and thermal conductivity of the heat flow control layer of the Pd material may be about 71 W/(m·K).

Also, for example, the first heat flow control layer 151 may include an ENIG layer or an ENEPIG layer, and the second heat flow control layer 152 may include a Ni plating layer.

Accordingly, according to an embodiment, a heat flow control layer 150 having lower thermal conductivity can be provided on one side surface of the body 110 in a direction adjacent to the second semiconductor device 212, and there is a technical effect that the flow of heat generated from the first semiconductor device 211 is further increased toward an upward direction, which is a position of the heat dissipation device 230, and the flow in a lateral direction is lowered, so that less damage can be given to the second semiconductor device 212.

Also, in an embodiment, the body 110 may include Cu of a rolled copper material. In an embodiment, as the body 110 has the rolled copper material, purity is higher than that of an electrolytic copper material, so thermal conductivity can be higher and heat dissipation efficiency can be improved, and since the rolled copper has high density and high rigidity, there is an advantage of excellent rigid design characteristics.

Also, in the first strain control device 101 of an embodiment, one side surface of the body 110 may include an inclined surface 110S. The inclined surface 110S of the one side surface of the body 110 can be inclined such that a distance spaced apart from the second semiconductor device 212 becomes farther toward the upper side, and accordingly, there is an effect that less damage can be given to the second semiconductor device 212 in the flow of heat generated from the first semiconductor device 211 to the heat dissipation device 230.

Also, in the first strain control device 101, a central portion of the body 110 may have a first width W1, and an upper side of the body 110 may have a second width W2 smaller than the first width W1.

For example, according to an embodiment, by controlling the first width W1 of the lower side of the body 110 to be larger than the second width W2 of the upper side, while expanding a contact area with the first semiconductor device 211 so that heat generated from the first semiconductor device 211 can efficiently move toward the heat dissipation device 230 in an upward direction, there is an effect that less thermal damage can be given to the second semiconductor device 212.

Also, in the first strain control device 101, a lower protective layer 120 may be disposed under the body 110, and a conductive paste layer 114 in a first region and a plurality of spaced apart first connection members 112 in a second region may be included. The lower protective layer 120 may be a solder resist, but is not limited thereto.

Referring back to FIG. 3B, according to an embodiment, a problem in which reliability is degraded by giving damage to the second semiconductor device 212 such as HBM in a process in which heat generated from the first semiconductor device 211 such as a logic chip is moved to a heat sink or a vapor chamber, etc., can be solved by controlling the flow of heat.

For example, according to an embodiment, by the first strain control device 101 disposed to overlap the first semiconductor device 211 vertically, a heat flow F1 in a first direction which is an upper side can be maximized, and a heat flow F2 in a second direction toward the second semiconductor device 212 such as HBM which is a side surface can be minimized by the heat flow control layer 150, so there is a technical effect that reliability can be improved by minimizing thermal damage to the second semiconductor device 212 such as a memory device.

For example, according to an embodiment, a heat flow control layer 150 having lower thermal conductivity may be provided on one side surface of the body 110 in a direction adjacent to the second semiconductor device 212, and accordingly, the flow of heat generated from the first semiconductor device 211 can maximize the heat flow F1 in the first direction which is an upper side where the heat dissipation device 230 is positioned, and by lowering the heat flow F2 in the second direction which is a side surface direction, there is a technical effect that less damage can be given to the second semiconductor device 212.

Also, as the heat flow control layer 150 has a composite layer of a plurality of heat flow control layers having lower thermal conductivity than the material of the body 110, for example, a first heat flow control layer 151 and a second heat flow control layer 152, the heat flow F2 in the second direction on the side surface can be further lowered, and accordingly, there is a technical effect that damage to the second semiconductor device 212 can be minimized while maximizing the heat flow F1 in the first direction in the upward direction.

Also, according to an embodiment, one side surface of the body 110 in the first strain control device 101 includes an inclined surface 110S, and a second width W2 of an upper side of the body 110 is smaller than a first width W1 of a central portion to increase a separation distance from the second semiconductor device 212, so that heat flow F2 in a second direction toward the second semiconductor device 212 can be minimized, and through this, there is a technical effect that reliability can be improved by minimizing thermal damage to the second semiconductor device 212 such as a memory device.

Also, according to an embodiment, as the first strain control device 101 includes a plurality of spaced apart first connection members 112 in a form of a solder ball under the body 110, thermal expansion stress due to heat generated from the first semiconductor device 211 can be distributed. Accordingly, occurrence of delamination due to cracks or voids that can occur in a connection member of a metal TIM material can be prevented, so that heat dissipation efficiency and junction reliability at an adhesive part can be improved.

Also, according to the strain control device 101 of the embodiment, by disposing the first connection member 112 including a conductive ball in an outer area or a corner area in consideration of a maximum strain occurrence region and disposing the conductive paste layer 114 in a central area, the first connection member 112 distributes thermal expansion stress due to heat generated from the first semiconductor device 211, thereby preventing delamination due to occurrence of cracks or voids to improve heat dissipation efficiency and junction reliability at an adhesive part, and also, according to an embodiment, there is a complex technical effect that heat conduction can increase by about 400 to 500% compared to a comparative technique by the conductive paste layer 114 disposed in a second region where strain is relatively less generated.

Next, FIG. 8 is a cross-sectional view of a second strain control device 102 according to an embodiment.

The second strain control device 102 may adopt technical characteristics of the first strain control device 101 described above, and hereinafter, description will be given focusing on main characteristics of the second strain control device 102.

According to internal research, when forming a conductive paste layer 114 on a body 110, a problem was studied in that a thickness of the conductive paste layer 114 is not uniform compared to a thickness of the first connection member 112.

For example, as a phenomenon occurs in which conductive paste layers 114 are clumped together by surface tension in a liquid state, a problem was studied in that the thickness is not uniform compared to the thickness of the first connection member 112.

According to the second strain control device 102 of the embodiment, by controlling a first roughness 110R1 of a first region where the conductive paste layer 114 is formed to be larger than a second roughness 110R2 in a second region where the first connection member 112 is disposed, a clumping phenomenon of the conductive paste layer 114 is minimized, so there is a technical effect that a thickness of the conductive paste layer 114 can be controlled uniformly.

For example, the first roughness 110R1 may be formed to be larger than the second roughness 110R2 in the second region by etching or plasma treatment on the first region where the conductive paste layer 114 is formed, but is not limited thereto.

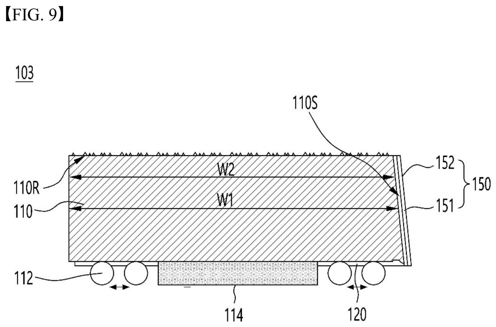

Next, FIG. 9 is a cross-sectional view of a third strain control device 103 according to an embodiment.

The third strain control device 103 may adopt technical characteristics of the first strain control device 101 or the second strain control device 102 described above, and hereinafter, description will be given focusing on main characteristics of the third strain control device 103.

The third strain control device 103 of the embodiment may include a concavo-convex portion 110R on an upper surface of a body 110 compared to the first strain control device 101.

In the third strain control device 103 of the embodiment, roughness of the concavo-convex portion 110R on the upper surface of the body 110 may be larger than roughness of an inclined surface 110S on one side surface of the body 110, but is not limited thereto.

Accordingly, as the concavo-convex portion 110R is provided on the upper surface of the body 110 of the third strain control device 103, junction reliability can be improved by lowering a possibility of delamination as an adhesive force and an adhesive area between the third strain control device 103 and a heat dissipation device 230 such as a vapor chamber are increased, and there is a technical effect that heat dissipation efficiency toward a heat flow F1 in a first direction which is an upper side can be maximized.

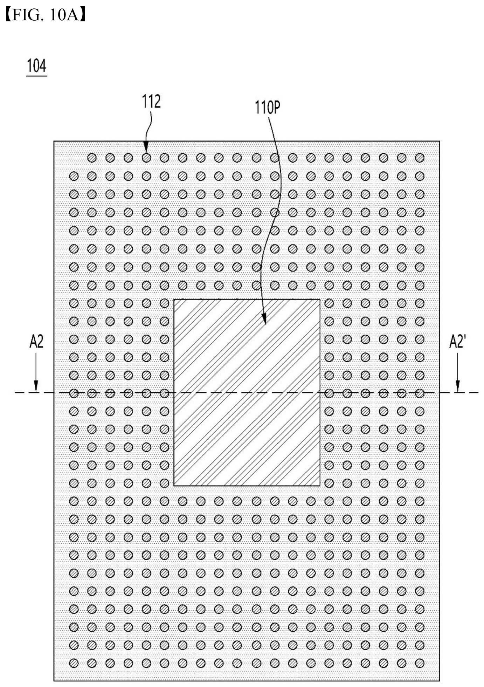

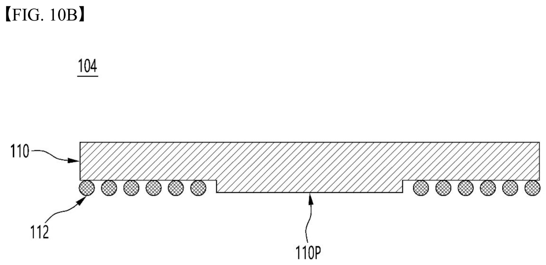

Next, FIG. 10A is a bottom view example of a fourth strain control device 104, and FIG. 10B is a cross-sectional view taken along line A2-A2' of the fourth strain control device 104 shown in FIG. 10A.

The fourth strain control device 104 may adopt technical characteristics of the first to third strain control devices 101, 102, and 103 described above, and hereinafter, description will be given focusing on main characteristics of the fourth strain control device 104.

The fourth strain control device 104 may include a body protrusion 110P in a first region of a body 110 and a first conductive connection member 112 disposed in a second region outside the first region. A plurality of body protrusions 110P may be disposed to be spaced apart on the body 110, but are not limited thereto.

According to the fourth strain control device 104 of the embodiment, a first connection member 112 including a conductive ball is disposed in an outer area or a corner area in consideration of a maximum strain occurrence region, and a body protrusion 110P may be disposed in a central area. Accordingly, while heat dissipation efficiency can be further improved by the body protrusion 110P in the central area, heat dissipation efficiency and junction reliability can be improved by distributing thermal expansion stress by the first connection member 112 disposed in the outer area.

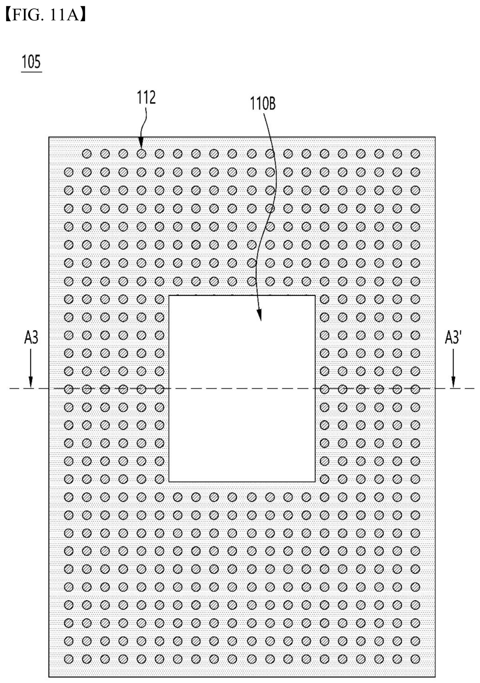

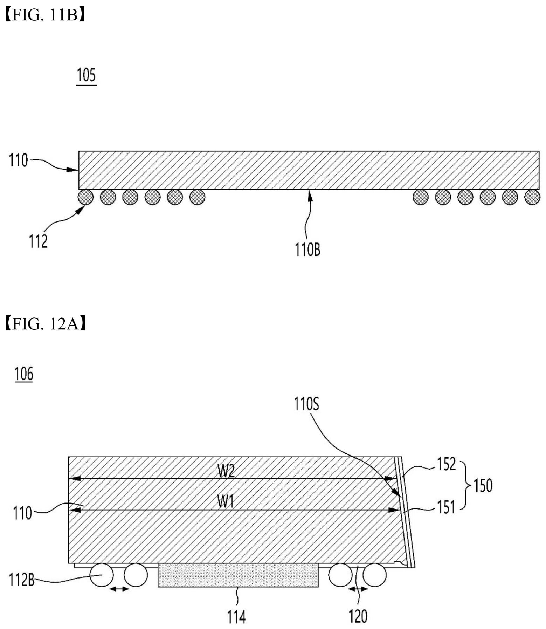

Next, FIG. 11A is a bottom view example of a fifth strain control device 105, and FIG. 11B is a cross-sectional view taken along line A3-A3' of the fifth strain control device 105 shown in FIG. 11A.

The fifth strain control device 105 may adopt technical characteristics of the first to fourth strain control devices 101, 102, 103, and 104 described above, and hereinafter, description will be given focusing on main characteristics of the fifth strain control device 105.

The fifth strain control device 105 may include an exposed portion 110B in a first region of a body 110 and a first conductive connection member 112 disposed in a second region outside the first region. A plurality of exposed portions 110B may be disposed to be spaced apart on the body 110, but are not limited thereto.

According to the fifth strain control device 105 of the embodiment, a first connection member 112 including a conductive ball is disposed in an outer area or a corner area in consideration of a maximum strain occurrence region, and an exposed portion 110B may be disposed in a central area or the like. Accordingly, thermal expansion stress is distributed by the first connection member 112 disposed in the outer area, and at the same time, stress due to warpage of thermal expansion can be further distributed by the exposed portion 110B, so that heat dissipation efficiency and junction reliability can be improved.

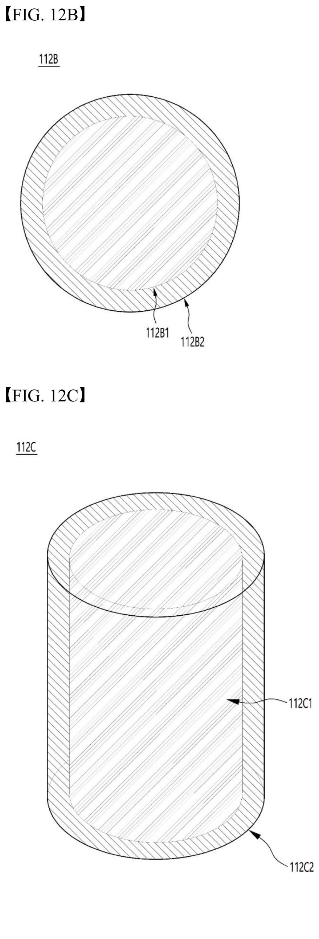

Next, FIG. 12A is a cross-sectional view of a sixth strain control device 106 according to an embodiment, FIG. 12B is a cross-sectional view of a first-second connection member 112B in the sixth strain control device 106, and FIG. 12C is a cross-sectional view of a first-third connection member 112C in the sixth strain control device 106.

The sixth strain control device 106 may adopt technical characteristics of the first to fifth strain control devices 101, 102, 103, 104, and 105 described above, and hereinafter, description will be given focusing on main characteristics of the sixth strain control device 106.

First, referring to FIG. 12B, a first-second connection member 112B in the sixth strain control device 106 may include a Cu ball structure. For example, the first-second connection member 112B may include a metal ball 112B1 and a solder cover layer 112B2 surrounding the metal ball 112B1. The metal ball 112B1 may be a Cu ball, but is not limited thereto.

According to the sixth strain control device 106, as the first-second connection member 112B includes a metal ball such as a Cu ball, there are technical effects that thermal conductivity can be improved and structural reliability can be improved.

Next, referring to FIG. 12C, a first-third connection member 112C in the sixth strain control device 106 may include a Cu Post structure. For example, the first-third connection member 112C may include a metal pillar 112C1 and a second solder cover layer 112C2 surrounding the metal pillar 112C1. The metal pillar 112C1 may be a Cu post, but is not limited thereto.

According to the sixth strain control device 106, as the first-third connection member 112C includes a metal pillar such as a Cu post, a height of the first-third connection member 112C can be controlled, and there are technical effects that thermal conductivity can be improved and structural reliability can be improved.

Next, FIG. 13A to FIG. 13C are exemplary views of semiconductor packages 210A3, 210A4, and 210A5 according to third to fifth embodiments.

Semiconductor packages 210A3, 210A4, and 210A5 according to the third to fifth embodiments may adopt technical characteristics of the first to second semiconductor packages 210A and 210B of the first to second embodiments described above, and hereinafter, characteristics of the semiconductor packages 210A3, 210A4, and 210A5 according to the third to fifth embodiments will be described.

Referring to FIG. 13A, a semiconductor package 210A3 according to a third embodiment may include a plurality of first semiconductor devices. For example, a semiconductor package 210A3 according to a third embodiment may include a first semiconductor device 211 disposed on a first package substrate 210a. Also, a semiconductor package 210A3 according to a third embodiment may include a second semiconductor device 212 disposed to be spaced apart on the first semiconductor device 211 and a strain control device 100.

The first semiconductor device 211 and the second semiconductor device 212 may include an active device and/or a passive device. For example, the active device may be a semiconductor chip in a form of an integrated circuit (IC) in which hundreds to millions or more of devices are integrated in one chip. Also, the first semiconductor device 211 may be a logic chip such as an AP or a SOC, and the second semiconductor device 212 may be a memory chip or the like, but is not limited thereto.

In the third embodiment, a size of the first semiconductor device 211 may be larger than a size of the second semiconductor device 212, but is not limited thereto.

In the third embodiment, the strain control device 100 can control the flow of heat generated from the first semiconductor device 211 toward the strain control device 100 by quickly and efficiently dissipating heat generated from the first semiconductor device 211 having a large size, thereby controlling the generated heat so as not to flow toward the second semiconductor device 212, and in the embodiment, the heat flow control device 100 may be disposed according to a main heat source from which heat is generated.

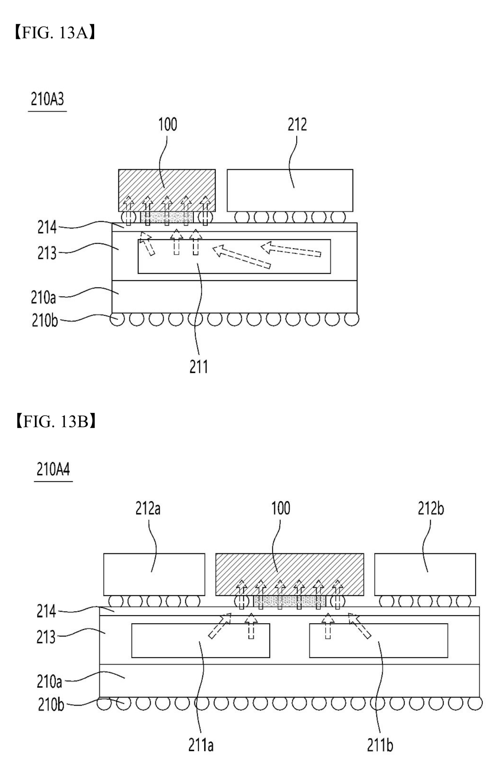

Next, referring to FIG. 13B, semiconductor packages 210A4 according to a fourth embodiment may include a plurality of second semiconductor devices. For example, a semiconductor package 210A4 according to the fourth embodiment may include a first-first semiconductor device 211a and a first-second semiconductor device 211b disposed on a first package substrate 210a. Also, the semiconductor package 210A4 according to the fourth embodiment may include a second-first semiconductor device 212a, a second-second semiconductor device 212b, and a strain control device 100 disposed to be spaced apart on the first-first semiconductor device 211a and the first-second semiconductor device 211b. The strain control device 100 may be disposed between the second-first semiconductor device 212a and the second-second semiconductor device 212b, but is not limited thereto.

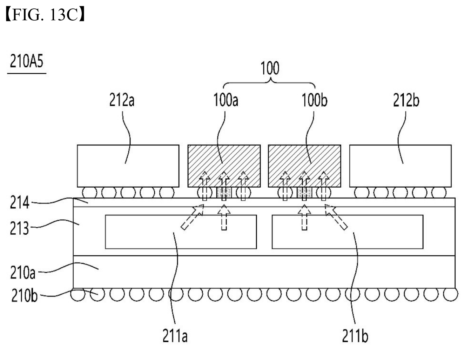

Next, referring to FIG. 13C, semiconductor packages 210A5 according to a fifth embodiment may include a plurality of strain control devices 100. For example, a semiconductor package 210A5 according to the fifth embodiment may include a first-first semiconductor device 211a and a first-second semiconductor device 211b disposed on a first package substrate 210a. Also, the semiconductor package 210A5 according to the fifth embodiment may include a second-first semiconductor device 212a, a second-second semiconductor device 212b, and a strain control device 100 disposed to be spaced apart on the first-first semiconductor device 211a and the first-second semiconductor device 211b. The strain control device 100 may include a first-first strain control device 100a and a first-second strain control device 100b disposed between the second-first semiconductor device 212a and the second-second semiconductor device 212b, but is not limited thereto.

Although the description has been given above with reference to the embodiments of the present invention, those skilled in the art will easily understand that the present invention can be variously modified and changed without departing from the spirit and scope of the present invention described in the following claims.

## Claims

1. A strain control device of a semiconductor package, comprising:
a body;
a plurality of spaced apart first connection members disposed in a first region under the body; and
a conductive paste layer disposed in a second region under the body.

2. The strain control device of a semiconductor package according to claim 1, wherein the conductive paste layer comprises any one or more of a solder paste layer, a metal paste, or a metal TIM, and
wherein the first connection member comprises a conductive ball.

3. The strain control device of a semiconductor package according to claim 1 or claim 2, wherein the first connection member is disposed in an outer area of the first region of the body.

4. The strain control device of a semiconductor package according to claim 3, wherein the conductive paste layer is disposed in a central area of the body, and
wherein the first connection member is disposed in outer areas on both sides of the body.

5. The strain control device of a semiconductor package according to any one of claims 1 to 4, wherein the conductive paste layer comprises a plurality of spaced apart conductive paste layers.

6. The strain control device of a semiconductor package according to claim 5, wherein the conductive paste layer comprises a first conductive paste layer disposed in a central area of the body, and a second conductive paste layer or a third conductive paste layer spaced apart from the first conductive paste layer in a horizontal direction and disposed in an outer area.

7. The strain control device of a semiconductor package according to claim 6, wherein the first connection member comprises the plurality of first connection members disposed in a corner area of the body, and
wherein at least one of the first connection members is disposed to overlap in a vertical direction with the second conductive paste layer or the third conductive paste layer spaced apart in the horizontal direction and disposed in the outer area.

8. The strain control device of a semiconductor package according to claim 7, wherein the conductive paste layer comprises a fourth conductive paste layer or a fifth conductive paste layer spaced apart from the first conductive paste layer in a vertical direction and disposed in an outer area, and
wherein the first connection member disposed in the corner area is disposed to overlap in the vertical direction with the third conductive paste layer or the fourth conductive paste layer spaced apart in the vertical direction and disposed in the outer area.

9. The strain control device of a semiconductor package according to any one of claims
1 to 8, wherein a first roughness of the first region where the conductive paste layer is formed is larger than a second roughness in the second region.

10. The strain control device of a semiconductor package according to any one of claims 1 to 9, wherein the body comprises a body protrusion.

11. The strain control device of a semiconductor package according to any one of claims 1 to 10, wherein the body comprises an exposed portion.

12. The strain control device of a semiconductor package according to any one of claims 1 to 11, wherein the first connection member comprises a metal ball and a solder cover layer surrounding the metal ball.

13. The strain control device of a semiconductor package according to any one of claims 1 to 12, further comprising a heat flow control layer disposed on a side surface of the body,
wherein the heat flow control layer comprises a plating layer.

14. A semiconductor package, comprising:
a first semiconductor device disposed on a first package substrate;
a strain control device disposed on the first semiconductor device; and
a second semiconductor device disposed to be spaced apart on a side surface of the first strain control device,
wherein the strain control device comprises the strain control device of a semiconductor package according to any one of claims 1 to 13.

15. A semiconductor module, comprising:
the semiconductor package according to claim 14.
